# FASCICULE DE BREVET EUROPEEN

(11) **EP 4 088 126 B1**
(45) Date de publication et mention de la délivrance du brevet: **20.11.2024**
(21) Numéro de dépôt: 20828043.8
(22) Date de dépôt: 03.12.2020
(51) Int. Cl.: G01R 31/389

(54) **DIAGNOSTIC D'ÉTAT D'UNE BATTERIE DE SERVITUDE D'UN VÉHICULE PAR IMPULSIONS DE COURANT**
DIAGNOSE DES ZUSTANDS EINER ZUSATZBATTERIE EINES FAHRZEUGS DURCH STROMIMPULSE
DIAGNOSIS OF THE CONDITION OF AN ACCESSORY BATTERY OF A VEHICLE BY CURRENT PULSES

(30) Priorité: 09.01.2020 FR 2000166
(43) Date de publication de la demande: 16.11.2022
(73) Titulaire: Stellantis Auto SAS, 78300 Poissy (FR)
(72) Inventeur: RIERA, Alexis, 78480 VERNEUIL SUR SEINE (FR); MIZWICKI, Eric, 95180 MENUCOURT (FR); DENEVE, Alexandre, 92270 BOIS COLOMBES (FR); PERSEVAL, Herve, 91310 MONTLHERY (FR); MONDOLONI, Christian, 78180 MONTIGNY LE BRETONNEUX (FR)
(86) Numéro de dépôt international: PCT/FR2020/052265
(87) Numéro de publication internationale: WO 2021/140283

(56) Documents cités:
- EP-A1- 1 068 540
- EP-A1- 1 548 452
- DE-A1- 102010 063 054
- DE-A1- 102015 204 497
- US-A1- 2003 206 021
- US-A1- 2006 186 890

## Description

La présente invention revendique la priorité de la demande française N°2000166 déposée le 09/01/2020.

### Domaine technique de l'invention

L'invention concerne les véhicules comprenant une batterie de servitude alimentant électriquement un réseau de bord, et plus précisément le diagnostic de l'état de leur batterie de servitude.

### Etat de la technique

De nombreux véhicules comprennent un réseau de bord comportant des équipements électroniques (ou électriques) consommant de l'énergie électrique. Comme le sait l'homme de l'art, cette énergie électrique est généralement fournie par une batterie de servitude de type très basse tension (par exemple 12 V, 24 V ou 48 V) ou, en l'absence d'alternateur ou en cas d'impossibilité d'utiliser ce dernier, par un convertisseur courant continu/courant continu (ou DC/DC) alimenté par une batterie rechargeable fournissant aussi de l'énergie électrique à une machine motrice électrique du groupe motopropulseur (ou GMP).

La disponibilité de la puissance électrique de la batterie de servitude est importante pour la sécurité de la conduite, car cette puissance électrique constitue, lorsque la batterie de servitude est correctement connectée au réseau de bord, la seule source électrique capable d'alimenter les fonctions sécuritaires du véhicule qui sont les plus exigeantes en puissance électrique, comme par exemple l'assistance de direction, l'assistance au freinage ou le contrôle de trajectoire. Il est donc essentiel de s'assurer que l'état de charge et l'état de santé de la batterie de servitude sont optimaux.

Pour les véhicules équipés d'un démarreur, la réussite du démarrage du groupe motopropulseur (ou GMP) est un critère qui, jusqu'à présent, est nécessaire et suffisant pour permettre au conducteur de rouler en sécurité. En effet, le démarreur consomme un courant électrique d'une telle intensité que seule une batterie de servitude en très bon état et correctement connectée peut délivrer. Dans ce cas, le seul fait de pouvoir démarrer le GMP constitue un diagnostic de l'état de la batterie de servitude, et plus précisément de la puissance disponible.

Les véhicules électrifiés (hybrides ou tout électrique) n'ont pas nécessairement un démarreur dont le fonctionnement fait office de diagnostic d'état de la batterie de servitude et/ou de ses connexions. De plus, une batterie de servitude très déchargée ou mal connectée peut délivrer une puissance suffisante pour activer le GMP et permettre le roulage, mais insuffisante pour alimenter les fonctions sécuritaires du véhicule. Par conséquent, le conducteur du véhicule peut débuter une phase de roulage voire enchaîner plusieurs phases de roulage sans savoir que sa batterie de servitude et/ou ses connexions sont incapables de satisfaire aux besoins des fonctions sécuritaires du véhicule.

Il a certes été proposé dans certains véhicule à GMP tout électrique d'évaluer l'état de la batterie de servitude au début de chaque roulage en commutant une résistance électrique pendant typiquement 200 ms sur le réseau de bord afin de prélever une impulsion de courant typiquement de 100 A à la batterie de servitude. Lorsque ce prélèvement s'effectue normalement, on considère que la batterie de servitude est dans un très bon état et donc capable de satisfaire aux besoins des fonctions sécuritaires du véhicule. Dans le cas contraire on considère que la batterie de servitude n'est pas dans un état suffisamment bon, et le conducteur en est informé. Cette solution ne peut être mise en oeuvre qu'avant une phase de roulage, car pendant un roulage le diagnostic serait faussé, d'une part, à cause de la consommation en parallèle des autres composants du réseau de bord, et, d'autre part, à cause de la production de puissance par le convertisseur DC/DC.

Or, dans certains véhicules il s'avère indispensable pour la sécurité de déterminer pendant les phases de roulage si leur batterie de servitude est en mesure de satisfaire au moins aux besoins de leurs fonctions sécuritaires. En outre, lorsque la batterie de servitude est défectueuse durant une phase de roulage, il n'y a pas d'instauration de fonctionnement en mode dégradé.

L'invention a donc notamment pour but d'améliorer la situation.

On connait en outre du document de brevet US-A1-2006186890 un véhicule conforme au préambule de la revendication 1.

### Présentation de l'invention

Elle propose notamment à cet effet un véhicule comprenant :
- une batterie de servitude alimentant électriquement un réseau de bord via des connexions, et
- au moins un processeur et au moins une mémoire agencés, lorsqu'un diagnostic de la batterie de servitude et de ses connexions est demandé, pour effectuer les opérations consistant à contrôler la génération d'au moins deux impulsions de courant successives et ayant un profil choisi pour que la batterie de servitude consomme un courant, et pendant chaque impulsion à déclencher au moins une mesure du courant consommé et d'une tension aux bornes de la batterie de servitude, puis à déterminer une résistance interne réelle à partir de ces courants consommés et tensions mesurés, puis à déclencher la délivrance d'un premier signal d'alerte lorsque cette résistance interne réelle est inférieure à un premier seuil choisi, chaque impulsion de courant comprenant une première partie ayant une durée comprise entre 4 ms et 8 ms et une intensité comprise entre 60 A et 120 A, et une seconde partie suivant cette première partie et ayant une durée comprise entre 4 ms et 8 ms et une intensité comprise entre 5 A et 15 A ;

Cette génération de plusieurs impulsions de courant successives permet avantageusement de connaître avec une excellente précision la valeur de la résistance interne réelle.

Le véhicule selon l'invention peut comporter d'autres caractéristiques qui peuvent être prises séparément ou en combinaison, et notamment :
- ses processeur et mémoire peuvent être agencés pour effectuer les opérations consistant à contrôler la génération de cinq impulsions de courant successives et ayant le profil choisi ;
- ses processeur et mémoire peuvent être agencés pour effectuer les opérations consistant à déterminer une résistance interne intermédiaire pour chaque impulsion de courant, puis à multiplier ces résistances internes intermédiaires respectivement par des premiers coefficients de pondération choisis afin d'obtenir des résistances internes pondérées, puis à déterminer la résistance interne réelle en effectuant une somme de ces résistances internes pondérées divisée par la somme de ces coefficients de pondération ;
- ses processeur et mémoire peuvent être agencés pour effectuer les opérations consistant à multiplier les tensions mesurées pour chaque impulsion de courant respectivement par des coefficients de pondération choisis afin d'obtenir des tensions pondérées, puis à déterminer une tension réelle en effectuant une somme de ces tensions pondérées divisée par la somme de ces coefficients de pondération ;
- il peut comprendre un interrupteur installé entre la batterie de servitude et le réseau de bord et ayant un état activé dans lequel il peut être ouvert ou fermé pour interdire ou autoriser le passage de courant. Dans ce cas, ses processeur et mémoire peuvent être agencés, lorsque le diagnostic de la batterie de servitude et de ses connexions est demandé, pour effectuer les opérations consistant à contrôler un placement de cet interrupteur dans son état activé puis son ouverture pour provoquer une décroissance d'une tension de la batterie de servitude, et, en cas de détection d'une différence entre les tensions de la batterie de servitude et du réseau de bord, à contrôler la génération des impulsions de courant successives ;
- ses processeur et mémoire peuvent être agencés pour effectuer les opérations consistant à contrôler l'ouverture de l'interrupteur en déclenchant la fourniture à ce dernier d'une autre impulsion de courant ;
- il peut comprendre un ensemble de composants électroniques générant, sur ordre des processeur et mémoire, le courant ayant le profil prédéfini.

L'invention propose également un procédé de diagnostic, d'une part, destiné à être mis en oeuvre dans un véhicule comprenant une batterie de servitude alimentant électriquement un réseau de bord via des connexions, et, d'autre part, comprenant une étape dans laquelle, lorsqu'un diagnostic de la batterie de servitude et de ses connexions est demandé :
- on contrôle une génération d'au moins deux impulsions de courant successives et ayant un profil choisi pour que la batterie de servitude consomme un courant, et pendant chaque impulsion on déclenche au moins une mesure d'un courant consommé par la batterie de servitude et d'une tension aux bornes de la batterie de servitude,
- puis on détermine une résistance interne réelle à partir de ces courants consommés et tensions mesurés, puis
- on déclenche la délivrance d'un premier signal d'alerte lorsque cette résistance interne réelle est inférieure à un premier seuil choisi, chaque impulsion de courant comprenant une première partie ayant une durée comprise entre 4 ms et 8 ms et une intensité comprise entre 60 A et 120 A, et une seconde partie suivant ladite première partie et ayant une durée comprise entre 4 ms et 8 ms et une intensité comprise entre 5 A et 15 A.

L'invention propose également un produit programme d'ordinateur comprenant un jeu d'instructions qui, lorsqu'il est exécuté par des moyens de traitement, est propre à mettre en oeuvre un procédé de diagnostic du type de celui présenté ci-avant pour diagnostiquer un état d'une batterie de servitude alimentant électriquement un réseau de bord d'un véhicule via des connexions.

### Brève description des figures

D'autres caractéristiques et avantages de l'invention apparaîtront à l'examen de la description détaillée ci-après, et des dessins annexés, sur lesquels :
[Fig. 1] illustre schématiquement et fonctionnellement un véhicule selon l'invention comprenant une chaîne de transmission hybride, un réseau de bord, une batterie de servitude et un dispositif de diagnostic,
[Fig. 2] illustre schématiquement et fonctionnellement un exemple de réalisation d'une logique de commande d'un dispositif de diagnostic,
[Fig. 3] illustre schématiquement, au sein d'un diagramme inférieur, un exemple de profil d'une impulsion de courant utilisée pour diagnostiquer la batterie de servitude et ses connexions, et au sein d'un diagramme supérieur, un exemple de courbe d'évolution temporelle (t) de la tension (v_{BS}) de la batterie de servitude avant, pendant et après la génération de l'impulsion de courant, et
[Fig. 4] illustre schématiquement un exemple d'algorithme mettant en oeuvre un procédé de diagnostic selon l'invention.

### Description détaillée de l'invention

L'invention a notamment pour but de proposer un véhicule V selon l'invention comprenant une batterie de servitude BS alimentant électriquement un réseau de bord RB via des connexions et un dispositif de diagnostic DD chargé de diagnostiquer de façon fiable l'état de cette batterie de servitude BS et de ses connexions, et un procédé de diagnostic associé.

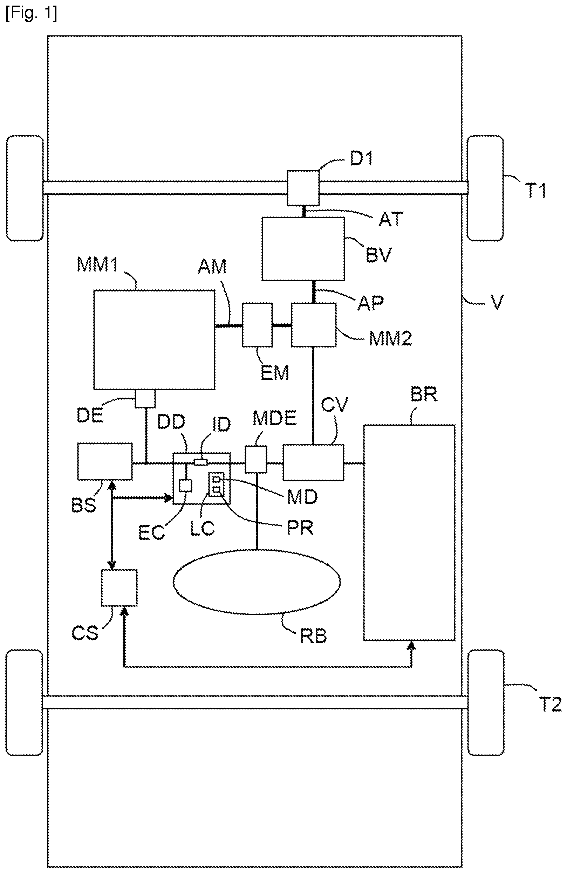

Dans ce qui suit, on considère, à titre d'exemple non limitatif, que le véhicule V est de type automobile. Il s'agit par exemple d'une voiture, comme illustré non limitativement sur la figure 1. Mais l'invention n'est pas limitée à ce type de véhicule. Elle concerne en effet tout type de véhicule comprenant une batterie de servitude alimentant électriquement un réseau de bord. Par conséquent, l'invention concerne non seulement les véhicules terrestres (y compris les motocyclettes), mais également les bateaux et les avions.

On a schématiquement représenté sur la figure 1 un véhicule V comprenant une chaîne de transmission, un réseau de bord RB, une batterie de servitude BS et ses connexions, et un dispositif de diagnostic DD.

Le réseau de bord RB comprend des équipements électroniques (ou électriques) qui consomment de l'énergie électrique. Certains de ces équipements électroniques assurent une fonction sécuritaire (comme par exemple l'assistance de direction, l'assistance au freinage ou le contrôle de trajectoire), et certains autres de ces équipements électroniques assurent une fonction non sécuritaire (comme par exemple l'éclairage intérieur, l'info-divertissement (ou « infotainment »), l'aide à la navigation ou le chauffage/climatisation).

La chaîne de transmission comprend ici, notamment, une première machine motrice MM1, un arbre moteur AM, un embrayage EM, une seconde machine motrice MM2 électrique, une boîte de vitesses BV, une batterie rechargeable BR et un arbre de transmission AT. Il est important de noter que la chaîne de transmission illustrée est de type hybride, mais elle pourrait être de type tout électrique en ayant un groupe motopropulseur ne comportant qu'au moins une machine motrice électrique, ou purement thermique.

On entend ici par « machine motrice » une machine agencée de manière à fournir ou récupérer du couple pour déplacer le véhicule V, soit seule soit en complément d'une autre machine motrice thermique ou électrique. Une machine motrice thermique peut, par exemple, être un moteur thermique.

On considère dans ce qui suit, à titre d'exemple non limitatif, que la première machine motrice MM1 est thermique. Il s'agit par exemple d'un moteur thermique. Mais l'invention n'est pas limitée à ce type de première machine motrice. En effet, la première machine motrice MM1 peut être thermique ou non-thermique (et notamment électrique).

Cette première machine motrice MM1 (ici un moteur thermique) comprend un vilebrequin (non représenté) qui est solidarisé fixement à l'arbre moteur AM afin d'entraîner ce dernier (AM) en rotation. Par ailleurs, cette première machine motrice MM1 est destinée à fournir un couple pour au moins un premier train T1 (ici de roues), via l'embrayage EM, la seconde machine motrice MM2, et la boîte de vitesses BV.

Par exemple, ce premier train T1 est situé à l'avant du véhicule V, et couplé à l'arbre de transmission AT, de préférence, et comme illustré, via un différentiel (ici avant) D1. Mais dans une variante ce premier train T1 pourrait être celui qui est ici référencé T2 et qui est situé à l'arrière du véhicule V.

L'embrayage EM est chargé de coupler/découpler l'arbre moteur AM (couplé à la première machine motrice MM1) à/de la seconde machine motrice MM2, sur ordre d'un calculateur de supervision du groupe motopropulseur, afin de communiquer un couple à partir du couple que produit la première machine motrice MM1.

La seconde machine motrice MM2 (électrique) est couplée à la batterie rechargeable BR, de préférence via un module de distribution électrique MDE installé en entrée du réseau de bord RB, afin d'être alimentée en énergie électrique, ainsi qu'éventuellement d'alimenter cette batterie rechargeable BR en énergie électrique. Elle est également couplée, ici, à la sortie de l'embrayage EM, et à l'arbre primaire AP de la boîte de vitesses BV, pour lui fournir du couple.

Par exemple, la batterie rechargeable BR peut être de type basse tension (typiquement 400 V à titre illustratif). Mais elle pourrait être de type très basse tension (typiquement 48 V) ou moyenne tension ou encore haute tension.

La boîte de vitesses BV comprend aussi au moins un arbre secondaire (non représenté) destiné à recevoir du couple via l'arbre primaire AP afin de le communiquer à l'arbre de transmission AT auquel il est couplé et qui est couplé indirectement aux roues motrices (ici avant) du véhicule V via le différentiel D1.

La batterie de servitude BS est chargée de fournir de l'énergie électrique au réseau de bord RB, ici via le module de distribution électrique MDE. Par exemple, cette batterie de servitude BS peut être agencée sous la forme d'une batterie de type très basse tension (typiquement 12 V, 24 V ou 48 V).

On notera que la batterie de servitude BS peut, comme illustré non limitativement, être couplée à la batterie rechargeable BR et à la seconde machine motrice MM2 via un convertisseur CV de type courant continu/courant continu (ou DC/DC), afin de pouvoir être rechargée.

On notera également, comme illustré non limitativement sur la figure 1, que la chaîne de transmission comprend ici un démarreur ou un alterno-démarreur DE couplé à la première machine motrice MM1 et chargé de lancer cette dernière (MM1) afin de lui permettre de démarrer. Ce lancement se fait grâce à de l'énergie électrique qui est, par exemple et comme illustré non limitativement, stockée dans la batterie de servitude BS.

Les fonctionnements des batterie de servitude BS et batterie rechargeable BR et de l'éventuel module de distribution électrique MDE peuvent être contrôlés par un calculateur de supervision CS en charge de la gestion de l'alimentation électrique du véhicule V.

Comme évoqué plus haut, le dispositif de diagnostic DD est chargé de diagnostiquer de façon fiable l'état de la batterie de servitude BS et de ses connexions. Comme illustré non limitativement sur la figure 1, il (DD) comprend à cet effet au moins un processeur PR et au moins une mémoire MD.

Le processeur PR peut, par exemple, être un processeur de signal numérique (ou DSP (« Digital Signal Processor »)). Ce processeur PR peut comprendre des circuits intégrés (ou imprimés), ou bien plusieurs circuits intégrés (ou imprimés) reliés par des connections filaires ou non filaires. On entend par circuit intégré (ou imprimé) tout type de dispositif apte à effectuer au moins une opération électrique ou électronique. Ainsi, il peut, par exemple, s'agir d'un microcontrôleur.

La mémoire MD est vive afin de stocker des instructions pour la mise en oeuvre par le processeur PR d'une partie au moins du procédé de diagnostic décrit plus loin.

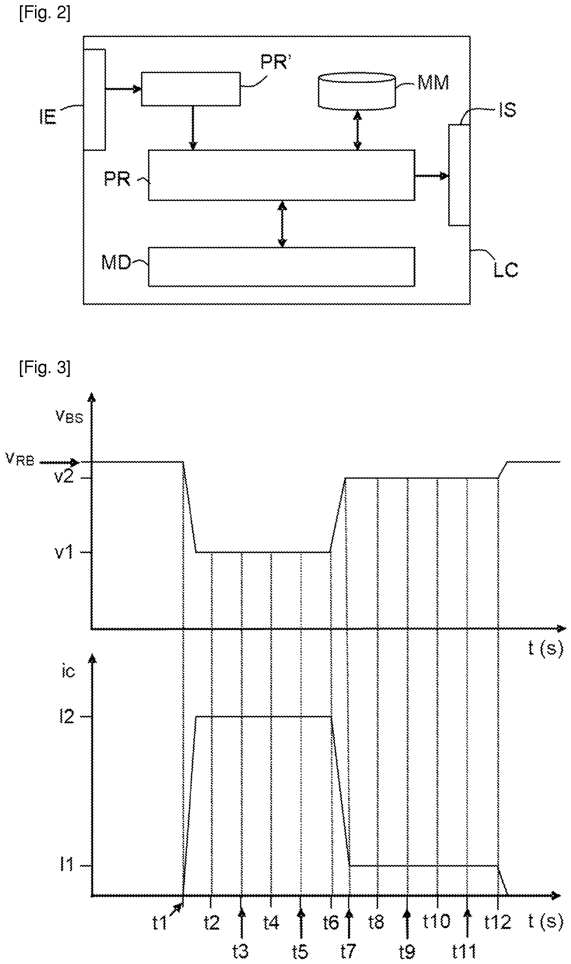

Comme illustré non limitativement sur les figures 1 et 2, le processeur PR et la mémoire MD peuvent faire partie d'une (ou éventuellement constituer une) logique de commande LC contrôlant la réalisation du diagnostic. On comprendra qu'étant donné que la logique de commande LC comprend au moins le processeur PR et au moins une mémoire MD, elle peut être réalisée sous la forme d'une combinaison de circuits ou composants électriques ou électroniques (ou « hardware ») et de modules logiciels (ou « software »).

On notera que dans l'exemple illustré non limitativement sur les figures 1 et 2, le processeur PR et la mémoire MD (et donc ici la logique de commande LC) font intégralement partie d'un boîtier qui est intercalé entre la batterie de servitude BS et le module de distribution électrique MDE. Mais dans une variante de réalisation non illustrée le processeur PR et la mémoire MD (et donc ici la logique de commande LC) pourraient faire partie du calculateur de supervision CS. Dans cette variante, le dispositif de diagnostic DD est donc réparti dans au moins deux équipements (le boîtier et le calculateur de supervision CS).

Cette logique de commande LC peut, par exemple, être alimentée en direct par la batterie de servitude BS, comme illustré non limitativement sur la figure 1. En variante, on pourrait prévoir un petit accumulateur chargé d'alimenter en énergie électrique au moins la logique de commande LC, ou bien cette dernière (LC) pourrait être alimentée indirectement par la batterie rechargeable BR, par exemple.

Le processeur PR et la mémoire MD interviennent chaque fois qu'un diagnostic de l'état de la batterie de servitude BS et de ses connexions est demandé par un équipement électronique du véhicule V, comme par exemple le calculateur de supervision CS. En présence d'une telle demande, ils sont tout d'abord agencés pour effectuer les opérations consistant à contrôler la génération d'au moins deux impulsions de courant ic successives et ayant un profil choisi pour que la batterie de servitude BS consomme un courant, et pendant chaque impulsion ic à déclencher au moins une mesure du courant consommé ccm et d'une tension v_{BS} aux bornes de la batterie de servitude BS.

Le processeur PR et la mémoire MD sont aussi agencés pour effectuer les opérations consistant à déterminer une résistance interne réelle rir à partir de ces courants consommés ccm et tensions v_{BS} mesurés, puis à déclencher la délivrance d'un premier signal d'alerte lorsque cette résistance interne réelle rir est inférieure à un premier seuil choisi. Il est rappelé que selon la loi d'ohm la résistance est égale à la tension divisée par le courant.

Grâce à cette génération de plusieurs impulsions de courant ic successives on peut désormais connaître avec une excellente précision la valeur de la résistance interne réelle rir.

On notera que chaque courant consommé mesuré ccm peut éventuellement être la valeur moyenne de N mesures directes (avec N ≥ 2), et chaque tension v_{BS} mesurée peut éventuellement être la valeur moyenne de N mesures directes. Par exemple, N peut être égal à 5 (mais il peut prendre n'importe quelle valeur supérieure ou égale à deux). Mais cela n'est pas obligatoire, car chaque courant consommé mesuré ccm peut être une mesure directe, et chaque tension v_{BS} peut être une mesure directe.

On notera également que le premier seuil peut être choisi égal à 5 mohms. Une batterie de servitude de type acide-plomb neuve et bien chargée a une résistance interne de 5 mohms à 20°C. La valeur de cette résistance interne augmente à basse température et/ou avec l'âge et/ou avec un faible état de charge. Par conséquent, la valeur du premier seuil peut être éventuellement variable en fonction de la température et/ou de l'état de la batterie de servitude BS.

Par exemple, les processeur PR et mémoire MD peuvent être agencés pour effectuer les opérations consistant à contrôler la génération de cinq impulsions de courant ic successives et ayant le profil choisi. Ce nombre égal à cinq n'est qu'un exemple, il doit être supérieur ou égal à deux et donc peut être inférieur à cinq (par exemple compris entre deux et quatre) ou supérieur à cinq (par exemple égal à six ou sept).

Egalement par exemple, et comme illustré non limitativement sur la figure 3, chaque impulsion de courant ic peut comprendre une première partie ayant une durée comprise entre 4 ms et 8 ms et une intensité i2 comprise entre 60 A et 120 A, et une seconde partie suivant cette première partie et ayant une durée comprise entre 4 ms et 8 ms et une intensité i1 comprise entre 5 A et 15 A. La première partie (ou pic) permet de déterminer si la batterie « répond » en puissance en même temps qu'elle permet de faire au moins une mesure de la résistance interne réelle rir. La seconde partie (ou palier) sert à empêcher que la batterie de servitude BS se polarise.

A titre d'exemple illustratif, la durée de la première partie peut être égale à 5 ms et l'intensité i2 de la première partie peut être égale à 100 A. Egalement à titre d'exemple illustratif, la durée de la seconde partie peut être égale à 5 ms et l'intensité i1 de la première partie peut être égale à 10 A.

Pour réaliser le profil à deux intensités i1 et i2, on peut utiliser deux résistances que l'on commute : une résistance permet de consommer un courant d'intensité i2 (par exemple 100 A) et une autre résistance permet de consommer un courant d'intensité i1 (par exemple 10 A). L'objectif est d'arriver à consommer au moins une valeur minimale de courant consommé (par exemple 60 A) de la batterie de servitude BS. En deçà de cette valeur minimale on considère que le diagnostic n'est pas robuste (performance insuffisante). Par exemple, si la logique de commande LC détecte que le courant consommé mesuré ccm (éventuellement moyenné) n'atteint pas la valeur minimale de courant consommé (par exemple 60 A), alors elle peut le signaler au calculateur de supervision CS qui comprend alors qu'il y a un échec de diagnostic qu'il interprète comme une batterie de servitude BS défectueuse (au sens disponibilité de sa puissance).

Sur la figure 3 se trouvent illustrés, d'une part, un diagramme inférieur montrant un exemple de profil d'une impulsion de courant ic utilisée pour diagnostiquer la batterie de servitude BS et ses connexions, et, d'autre part, un diagramme supérieur montrant un exemple de courbe d'évolution temporelle (t) de la tension v_{BS} de la batterie de servitude BS avant, pendant et après la génération de l'impulsion de courant ic du diagramme inférieur. Dans cet exemple, la tension v_{BS} de la batterie de servitude BS avant le début (à t1) de l'impulsion de courant ic est égale à celle (v_{RB}) du réseau de bord RB, laquelle est supérieure à une tension v2 (par exemple égale à 14 V).

La génération de l'impulsion de courant ic débute à l'instant t1 et se termine à l'instant t12. La première partie (ou pic) de l'impulsion de courant ic débute à l'instant t1 et se termine à l'instant t6 et provoque une forte baisse de la tension v_{BS} (jusqu'à une valeur v1, par exemple égale à 11,5 V (quand la batterie de servitude BS est en bon état). La seconde partie (ou palier) de l'impulsion de courant ic débute à l'instant t7 et se termine à l'instant t12 et provoque une remontée de la tension v_{BS} jusqu'à la valeur v2. Après l'instant t12 (et donc après l'impulsion de courant ic), la tension v_{BS} remonte jusqu'à la valeur v_{RB} de la tension du réseau de bord RB. Initialement, tout le réseau de bord RB est à la tension du générateur, typiquement 14 V. Lorsque l'interrupteur ID du dispositif de diagnostic DD (décrit plus loin) s'ouvre, le réseau de bord RB reste à 14 V et la batterie de servitude BS reste également à 14 V (elle est polarisée). La tension v_{BS} côté batterie de servitude BS diminue lentement (elle se dépolarise). Pour accélérer la dépolarisation, on peut, par exemple, générer une impulsion de courant (ou « blank pulse ») ic'. Une fois la batterie de servitude BS dépolarisée, sa tension v_{BS} est inférieure à 14V, par exemple 12 V ou 13 V. C'est alors qu'on génère les au moins deux impulsions de courant ic qui induisent une consommation de courant (par exemple de 100 A) par la batterie de servitude BS et provoque une baisse de sa tension v_{BS}, typiquement vers 11,5 V (V1). On a alors v_{BS} = E0 - ri, où I est le courant consommé (ici 100 A) et E0 est la tension à vide. La tension v_{BS} remonte ensuite à V2 car le prélèvement de courant est moindre (v_{BS} = E0 - ri, avec I = 10 A). Ensuite, la tension v_{BS} remonte à la tension à vide E0.

On notera que les processeur PR et mémoire MD peuvent être agencés pour effectuer les opérations consistant à déterminer une résistance interne intermédiaire rii (résultant éventuellement d'une moyenne de N résistances internes déduites des mesures directes ccm et v_{BS} effectuées par exemple aux instants t2 à t6 de la figure 3) pour chaque impulsion de courant ic, puis à multiplier les résistances internes intermédiaires rii respectivement par des premiers coefficients de pondération choisis afin d'obtenir des résistances internes pondérées rip. Ensuite, les processeur PR et mémoire MD peuvent être agencés pour effectuer les opérations consistant à déterminer la résistance interne réelle rir en effectuant la somme de ces résistances internes pondérées rip divisée par la somme des premiers coefficients de pondération. Ainsi, en présence de cinq impulsions de courant ic successives on aura rir = (rii1 *a1 + rii2*a2 + rii3*a3 + rii4*a4 + rii5*a5)/( a1 + a2 + a3 + a4 + a5).

On peut utiliser une cartographie prédéfinie de l'état en fonction de la résistance interne réelle rir et d'une tension réelle vr (déduite des mesures et décrite plus loin) pour déterminer si l'état réel de la batterie de servitude BS et de ses connexions est suffisamment bon pour permettre à la fois le roulage et l'alimentation de toutes les fonctions sécuritaires du véhicule V, ou bien si cet état permet le roulage et l'alimentation d'une partie seulement des fonctions sécuritaires du véhicule V, ou encore si cet état ne permet que le roulage.

Par exemple, si la batterie de servitude BS et/ou ses connexions est/sont considérée(s) inaptes à délivrer la puissance minimale sécuritaire, le conducteur en est averti par le premier signal d'alerte et il peut continuer son roulage (il y a donc une continuité de service). En contrepartie, certaines fonctionnalités du véhicule V peuvent être limitées (ou dégradées) afin de garantir la sécurité du roulage. On améliore ainsi réellement la sécurité du roulage et le pourcentage de détection des défaillances. Cet avantage est particulièrement utile dans le cas de fonctions de sécurité tout électrique, comme par exemple l'assistance au freinage tout électrique, mais également dans le cas d'une combinaison de plusieurs fonctions de sécurité dans le contexte d'une conduite automatisée (ou autonome).

Les processeur PR et mémoire MD peuvent être agencés pour effectuer les opérations consistant à multiplier les tensions v_{BS} mesurées pour chaque impulsion de courant ic (et résultant éventuellement d'une moyenne de N tensions déduites des mesures directes v_{BS} effectuées par exemple aux instants t2 à t6 de la figure 3) respectivement par des seconds coefficients de pondération choisis afin d'obtenir des tensions pondérées vp. Ensuite, les processeur PR et mémoire MD peuvent être agencés pour effectuer les opérations consistant à déterminer la tension réelle vr en effectuant la somme de ces tensions pondérées vp divisée par la somme des seconds coefficients de pondération. Ainsi, en présence de cinq impulsions de courant ic successives on aura vr = (v_{BS1}*a1' + v_{BS2}*a2' + v_{BS3}*a3' + v_{BS4}*a4' + v_{BS5}*a5')/( a1' + a2' + a3' + a4' + a5').

On notera également que les impulsions de courant ic peuvent être produites sur ordre des processeur PR et mémoire MD par le convertisseur CV ou par un éventuel interrupteur ID, que comprend le dispositif de diagnostic DD (comme illustré non limitativement sur la figure 1) et qui est installé en série entre la batterie de servitude BS et le réseau de bord RB (et plus précisément ici entre la batterie de servitude BS et le module de distribution électrique MDE).

Lorsque c'est le convertisseur CV qui est utilisé, il fonctionne en mode dit « boost » (ou élévateur de tension) afin de générer les impulsions de courant ic. Cette solution ne peut cependant être mise en oeuvre que dans des phases de vie spécifiques, typiquement lorsque les fonctions sécuritaires ne sont pas sollicitées (comme à faible vitesse), car elle revient à couper le générateur du réseau de bord RB (qui devient ponctuellement consommateur).

Le diagnostic de la batterie de servitude BS et de ses connexions pendant une phase de roulage permet de détecter les défaillances de la batterie de servitude BS et/ou de ses connexions (comme par exemple des défauts francs tels que des circuits ouverts, courts-circuits ou déconnexions suite à des vibrations ou des chocs lors d'un passage sur un nid de poule ou un ralentisseur).

Lorsque le convertisseur CV est en mode boost, il génère les impulsions de courant ic successives, et l'énergie de ces dernières (ic) doit aller dans un consommateur, typiquement la batterie rechargeable BR. Mais si cette dernière (BR) est très chargée et/ou trop froide, et donc incapable de consommer cette énergie, les processeur PR et mémoire MD peuvent déclencher l'activation d'un consommateur électrique alimenté par la batterie rechargeable BR (comme par exemple une machine motrice électrique, un compresseur de climatisation ou un réchauffeur).

L'éventuel interrupteur ID a un état activé dans lequel il peut être ouvert pour interdire le passage de courant ou bien fermé pour autoriser le passage de courant. Il a aussi un état désactivé dans lequel il autorise en permanence le passage de courant entre la batterie de servitude BS et le réseau de bord RB, sans conditions de sens de circulation (et donc dans les deux sens). Cet état désactivé est l'état par défaut de l'interrupteur ID lorsque le dispositif de diagnostic DD n'est pas dans une phase de diagnostic.

En d'autres termes, dans l'état activé fermé comme dans l'état désactivé l'interrupteur ID se comporte comme une résistance de très faible valeur (typiquement de l'ordre du milliohm), tandis que dans l'état activé ouvert l'interrupteur ID se comporte comme une diode idéale.

A titre d'exemple illustratif, l'interrupteur ID peut comprendre au moins un composant électronique de puissance (comme par exemple un MOSFET (« Metal Oxide Semiconductor Field Effect Transistor » - transistor à effet de champ à grille isolée), éventuellement à enrichissement de type n (ou nMOS)), et une diode (éventuellement de type Zener), montés en parallèle entre la batterie de servitude BS et le réseau de bord RB. En variante, l'interrupteur ID peut comprendre uniquement un ou plusieurs composants électroniques de puissance de type nMOS.

Lorsqu'un diagnostic de l'état de la batterie de servitude BS et de ses connexions est demandé par un équipement électronique du véhicule V, comme par exemple le calculateur de supervision CS, le processeur PR et la mémoire MD sont agencés pour effectuer les opérations consistant à contrôler le placement de l'interrupteur ID dans son état activé (alors qu'il était dans son état désactivé), puis son ouverture pour provoquer la décroissance de la tension v_{BS} de la batterie de servitude BS (et donc sa dépolarisation).

Cette décroissance est réalisée car la batterie de servitude BS peut être dans une phase où elle n'accepte plus de charge du fait que sa tension v_{BS} est à l'équilibre avec la tension v_{RB} du réseau de bord RB et donc la tension qui est ici produite par le convertisseur DC/DC CV, et par conséquent sans chute de tension on ne peut pas savoir si l'interrupteur ID est ouvert puisqu'aucun courant ne passe du réseau de bord RB vers la batterie de servitude BS.

Puis, lorsque le processeur PR et la mémoire MD détectent une différence dv entre les tensions v_{BS} et v_{RB}, ils contrôlent la génération des impulsions de courant ic successives.

Grâce à la différence dv entre les tensions v_{BS} et v_{RB} on est certain que la batterie de servitude BS est effectivement isolée du réseau de bord RB (et donc du convertisseur DC/DC CV), tout en permettant un éventuel appel de courant dans les situations d'urgence, et donc qu'elle peut être testée indépendamment de ces derniers (RB et CV), permettant ainsi d'obtenir un diagnostic fiable de son état en cours et de l'état de ses connexions.

On notera qu'en l'absence de différence dv entre les tensions v_{BS} et v_{RB} après l'ouverture de l'interrupteur ID, le dispositif de diagnostic DD considère qu'il y a un problème et donc alerte le calculateur de supervision CS, par exemple en plaçant un paramètre de diagnostic à une valeur spécifique.

Par exemple, le processeur PR et la mémoire MD peuvent être agencés pour effectuer les opérations consistant à contrôler l'ouverture de l'interrupteur ID en déclenchant la fourniture à ce dernier (ID) de l'impulsion de courant (ou blank pulse) ic'. Cette dernière (ic') peut, par exemple, avoir une durée inférieure à 10 ms et une intensité supérieure à 10 A. Cette impulsion de courant ic' très courte et de forte intensité provoque une circulation d'un courant vers la masse et donc accélère la dépolarisation. A titre d'exemple, la durée précitée peut être choisie égale à 5 ms et l'intensité précitée peut être choisie égale à 100 A.

On notera également, comme illustré non limitativement sur la figure 1, que le véhicule V peut comprendre un ensemble de composants électroniques EC agencé de manière à générer, sur ordre du processeur PR et de la mémoire MD, les impulsions de courant ic. Comme illustré, cet ensemble EC peut faire partie d'un boîtier comprenant l'interrupteur ID et la logique de commande LC (avec son processeur PR et sa mémoire MD). Mais cela n'est pas obligatoire. En effet, il pourrait être externe à ce boîtier mais couplé à la logique de commande LC.

A titre d'exemple illustratif, l'ensemble de composants électroniques EC peut comprendre deux sous-branches montées en parallèle entre la masse et le circuit couplant la batterie de servitude BS au réseau de bord RB, via une résistance de puissance (de préférence typée énergie). Dans ce cas, la première sous-branche peut comprendre au moins un composant électronique de puissance (comme par exemple un MOSFET, éventuellement à enrichissement de type n (ou nMOS)), et une diode (éventuellement de type Zener), montés en parallèle. De son côté la seconde sous-branche peut comprendre une résistance de puissance (de préférence typée énergie) montée en série avec au moins un composant électronique de puissance (comme par exemple un MOSFET, éventuellement à enrichissement de type n (ou nMOS)) monté en parallèle avec une diode (éventuellement de type Zener).

On notera également, comme illustré non limitativement sur la figure 2, que la logique de commande LC (qui peut être répartie) peut aussi comprendre, en complément de sa mémoire vive MD et de son processeur PR, une mémoire de masse MM, notamment pour le stockage des résistances internes mesurées, des tensions mesurées, et de données intermédiaires intervenant dans tous ses calculs et traitements. Par ailleurs, cette logique de commande LC peut aussi comprendre une interface d'entrée IE pour la réception d'au moins les valeurs des résistances internes mesurées et des tensions mesurées et des demandes de diagnostic (issues du calculateur de supervision CS) pour les utiliser dans des calculs ou traitements, éventuellement après les avoir mises en forme et/ou démodulées et/ou amplifiées, de façon connue en soi, au moyen d'un processeur de signal numérique PR'. De plus, cette logique de commande LC peut aussi comprendre une interface de sortie IS, notamment pour délivrer ses ordres ou commandes (au moins pour l'interrupteur ID et l'ensemble EC, ou bien pour le convertisseur CV) et les résultats de ses diagnostics (au moins pour le calculateur de supervision CS).

L'invention peut aussi être considérée sous la forme d'un procédé de diagnostic destiné à être mis en oeuvre dans le véhicule V. Ce procédé de diagnostic peut être mis en oeuvre au moins partiellement par le dispositif de diagnostic DD.

Ce procédé de diagnostic comprend une étape 10-140 dans laquelle, lorsqu'un diagnostic de la batterie de servitude BS et de ses connexions est demandé, on contrôle la génération d'au moins deux impulsions de courant ic successives et ayant un profil choisi pour que la batterie de servitude BS consomme un courant, et pendant chaque impulsion ic on déclenche au moins une mesure du courant consommé par la batterie de servitude BS et de la tension v_{BS} aux bornes de la batterie de servitude BS, puis on détermine une résistance interne réelle rir à partir de ces courants consommés et tensions v_{BS} mesurés, puis on déclenche la délivrance d'un premier signal d'alerte lorsque la résistance interne réelle rir est inférieure à un premier seuil choisi.

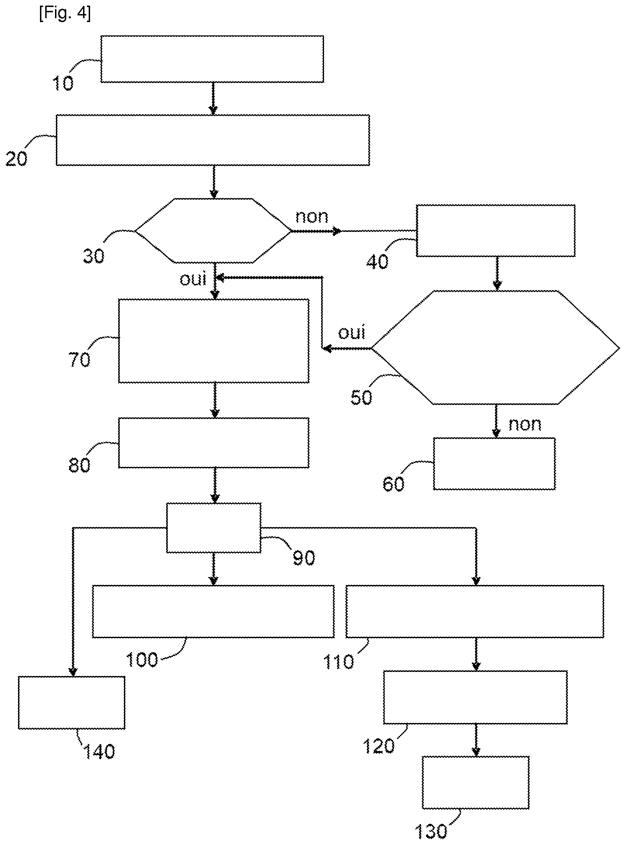

On a schématiquement illustré sur la figure 4 un exemple d'algorithme mettant en oeuvre un procédé de diagnostic selon l'invention.

L'algorithme comprend une sous-étape 10 dans laquelle on reçoit une demande de diagnostic de la batterie de servitude BS et de ses connexions. Puis, dans une sous-étape 20, on déclenche le placement de l'interrupteur ID dans son état activé, puis son ouverture.

Puis, dans une sous-étape 30 on détermine s'il y a une différence dv entre les tensions de la batterie de servitude BS et du réseau de bord RB.

En l'absence de différence dv on peut éventuellement déclencher dans une sous-étape 40 une temporisation d'une durée dt. Puis, dans une sous-étape 50 on peut déterminer s'il y a une différence dv entre les tensions de la batterie de servitude BS et du réseau de bord RB et si la durée dt a expiré. En présence de la différence dv et si la durée dt n'a pas expiré, on effectue une sous-étape 70. En revanche, si la durée dt a expiré et qu'il n'y a pas de différence dv, on place dans une sous-étape 60 un paramètre de diagnostic à une valeur spécifique signalant un problème.

En revanche, en présence d'une différence dv, on déclenche dans la sous-étape 70 la génération d'au moins deux impulsions de courant ic successives et ayant le profil choisi pour que la batterie de servitude BS consomme un courant ccm, et pendant chaque impulsion ic on déclenche au moins une mesure du courant ccm consommé par la batterie de servitude BS et de la tension v_{BS} aux bornes de la batterie de servitude BS.

Puis, dans une sous-étape 80 on détermine une résistance interne réelle rir à partir de ces courants consommés ccm et tensions v_{BS} mesurés.

Puis, dans une sous-étape 90 on détermine l'état de la batterie de servitude BS et de ses connexions.

Si la batterie de servitude BS et ses connexions sont diagnostiquées en bon état (résistance interne réelle rir supérieure au premier seuil choisi), rien ne se passe, hormis une mise à zéro d'un compteur d'incertitude relatif à l'état de la batterie de servitude BS dans une sous-étape 100.

Si la batterie de servitude BS et ses connexions sont diagnostiquées incertaines, il n'est pas possible de décider de leur état. La batterie de servitude BS peut en effet être déchargée, froide ou sulfatée, par exemple. Dans ce cas on incrémente dans une sous-étape 110 le compteur d'incertitude et on attend le prochain diagnostic pour vérifier si l'état de la batterie de servitude BS et de ses connexions évolue. Lorsque le compteur d'incertitude atteint dans une sous-étape 120 une valeur prédéfinie, par exemple égale à 10, cela signifie que l'état de la batterie de servitude BS et de ses connexions ne s'est pas amélioré, et donc on délivre dans une sous-étape 130 un second signal d'alerte pour informer le conducteur du véhicule V de la nécessité d'une intervention.

Si la batterie de servitude BS et ses connexions sont diagnostiquées en mauvais état (résistance interne réelle rir inférieure au premier seuil choisi) cela signifie que l'état de la batterie de servitude BS et de ses connexions ne permet pas de garantir la tension minimale de fonctionnement des équipements électroniques sécuritaires, et donc on délivre dans une sous-étape 140 le premier signal d'alerte pour informer le conducteur du véhicule V de la nécessité de s'arrêter le plus vite possible. Afin de garantir au conducteur un arrêt en toute sécurité, on peut commander l'arrêt des équipements électroniques délestables afin de garantir un maximum de disponibilité de la puissance du convertisseur CV pour alimenter les équipements électroniques sécuritaires et les équipements électroniques standards (non sécuritaires).

On notera également que l'invention propose aussi un produit programme d'ordinateur (ou programme informatique) comprenant un jeu d'instructions qui, lorsqu'il est exécuté par des moyens de traitement de type circuits électroniques (ou hardware), comme par exemple le processeur PR, est propre à mettre en oeuvre le procédé de diagnostic décrit ci-avant pour diagnostiquer l'état de la batterie de servitude BS du véhicule V et des connexions de cette batterie de servitude BS.

On notera également qu'une ou plusieurs sous-étapes de l'étape du procédé de diagnostic peuvent être effectuées par des composants différents. Ainsi, le procédé de diagnostic peut-être mis en oeuvre par une pluralité de processeurs de signal numérique, mémoire vive, mémoire de masse, interface d'entrée, interface de sortie.

## Revendications

1. Véhicule (V) comprenant une batterie de servitude (BS) alimentant électriquement un réseau de bord (RB) via des connexions, et comprenant en outre au moins un processeur (PR) et au moins une mémoire (MD) agencés, lorsqu'un diagnostic de ladite batterie de servitude (BS) et de ses connexions est demandé, pour effectuer les opérations consistant à contrôler une génération d'au moins deux impulsions de courant successives et ayant un profil choisi pour que ladite batterie de servitude (BS) consomme un courant, et pendant chaque impulsion à déclencher au moins une mesure d'un courant consommé par ladite batterie de servitude (BS) et d'une tension aux bornes de ladite batterie de servitude (BS), puis à déterminer une résistance interne réelle à partir de ces courants consommés et tensions mesurés, puis à déclencher la délivrance d'un premier signal d'alerte lorsque ladite résistance interne réelle est inférieure à un premier seuil choisi, **caractérisé en ce que** chaque impulsion de courant comprend une première partie ayant une durée comprise entre 4 ms et 8 ms et une intensité comprise entre 60 A et 120 A, et une seconde partie suivant ladite première partie et ayant une durée comprise entre 4 ms et 8 ms et une intensité comprise entre 5 A et 15 A.

2. Véhicule selon la revendication 1, **caractérisé en ce que** lesdits processeur (PR) et mémoire (MD) sont agencés pour effectuer les opérations consistant à contrôler la génération de cinq impulsions de courant successives et ayant ledit profil choisi.

3. Véhicule selon l'une des revendications 1 à 2, **caractérisé en ce que** lesdits processeur (PR) et mémoire (MD) sont agencés pour effectuer les opérations consistant à déterminer une résistance interne intermédiaire pour chaque impulsion de courant, puis à multiplier ces résistances internes intermédiaires respectivement par des premiers coefficients de pondération choisis afin d'obtenir des résistances internes pondérées, puis à déterminer ladite résistance interne réelle en effectuant une somme desdites résistances internes pondérées divisée par la somme desdits coefficients de pondération.

4. Véhicule selon l'une des revendications 1 à 3, **caractérisé en ce que** lesdits processeur (PR) et mémoire (MD) sont agencés pour effectuer les opérations consistant à multiplier lesdites tensions mesurées pour chaque impulsion de courant respectivement par des coefficients de pondération choisis afin d'obtenir des tensions pondérées, puis à déterminer une tension réelle en effectuant une somme desdites tensions pondérées divisée par la somme desdits coefficients de pondération.

5. Véhicule selon l'une des revendications 1 à 4, **caractérisé en ce qu'**il comprend un interrupteur (ID) installé entre ladite batterie de servitude (BS) et ledit réseau de bord (RB) et ayant un état activé dans lequel il peut être ouvert ou fermé pour interdire ou autoriser le passage de courant, et **en ce que** lesdits processeur (PR) et mémoire (MD) sont agencés, lorsque ledit diagnostic de la batterie de servitude (BS) et de ses connexions est demandé, pour effectuer les opérations consistant à contrôler un placement dudit interrupteur (ID) dans son état activé puis son ouverture pour provoquer une décroissance d'une tension de ladite batterie de servitude (BS), et, en cas de détection d'une différence entre les tensions de ladite batterie de servitude (BS) et dudit réseau de bord (RB), à contrôler ladite génération des impulsions de courant successives.

6. Véhicule selon la revendication 5, **caractérisé en ce que** lesdits processeur (PR) et mémoire (MD) sont agencés pour effectuer les opérations consistant à contrôler ladite ouverture de l'interrupteur (ID) en déclenchant la fourniture à ce dernier (ID) d'une autre impulsion de courant.

7. Véhicule selon l'une des revendications 1 à 6, **caractérisé en ce qu'**il comprend un ensemble de composants électroniques (EC) générant, sur ordre desdits processeur (PR) et mémoire (MD), ledit courant ayant le profil prédéfini.

8. Procédé de diagnostic pour un véhicule (V) comprenant une batterie de servitude (BS) alimentant électriquement un réseau de bord (RB) via des connexions, et comprenant une étape (10-140) dans laquelle, lorsqu'un diagnostic de ladite batterie de servitude (BS) et de ses connexions est demandé, on contrôle une génération d'au moins deux impulsions de courant successives et ayant un profil choisi pour que ladite batterie de servitude (BS) consomme un courant, et pendant chaque impulsion on déclenche au moins une mesure d'un courant consommé par ladite batterie de servitude (BS) et d'une tension aux bornes de ladite batterie de servitude (BS), puis on détermine une résistance interne réelle à partir de ces courants consommés et tensions mesurés, puis on déclenche la délivrance d'un premier signal d'alerte lorsque ladite résistance interne réelle est inférieure à un premier seuil choisi, **caractérisé en ce que** chaque impulsion de courant comprend une première partie ayant une durée comprise entre 4 ms et 8 ms et une intensité comprise entre 60 A et 120 A, et une seconde partie suivant ladite première partie et ayant une durée comprise entre 4 ms et 8 ms et une intensité comprise entre 5 A et 15 A.

9. Produit programme d'ordinateur comprenant un jeu d'instructions qui, lorsqu'il est exécuté par des moyens de traitement, est propre à mettre en oeuvre le procédé de diagnostic selon la revendication 8 pour diagnostiquer un état d'une batterie de servitude (BS) alimentant électriquement un réseau de bord (RB) d'un véhicule (V) via des connexions.

## Patentansprüche

1. Fahrzeug (V), umfassend eine Nutzbatterie (BS), die über Anschlüsse ein Bordnetz (RB) elektrisch versorgt, und weiterhin umfassend mindestens einen Prozessor (PR) und mindestens einen Speicher (MD) , der angeordnet ist,
wenn eine Diagnose der genannten Versorgungsbatterie (BS) und ihrer Anschlüsse angefordert wird, die Vorgänge auszuführen, die darin bestehen, die Erzeugung von mindestens zwei aufeinanderfolgenden Stromimpulsen zu steuern und ein Profil so zu wählen, dass die genannte Versorgungsbatterie ( BS) einen Strom verbraucht, und während jedes Impulses mindestens eine Messung eines Stroms auszulösen der von der Versorgungsbatterie (BS) verbraucht wird , und einer Spannung an den Anschlüssen der Versorgungsbatterie (BS), dann wird aus diesen gemessenen verbrauchten Strömen und Spannungen ein tatsächlicher Innenwiderstand bestimmt, und dann wird bei Erreichen des tatsächlichen Innenwiderstands die Abgabe eines ersten Alarmsignals ausgelöst kleiner als ein erster gewählter Schwellenwert ist, **dadurch gekennzeichnet, dass** jeder Impuls Der Strom umfasst einen ersten Teil mit einer Dauer zwischen 4 ms und 8 ms und einer Intensität zwischen 60 A und 120 A und einen zweiten Teil, der auf den ersten Teil folgt und eine Dauer zwischen 4 ms und 8 ms und eine Intensität zwischen 60 A und 120 A aufweist 5 A und 15 A.

2. Fahrzeug nach Anspruch 1, **dadurch gekennzeichnet**
Prozessor (PR) und Speicher (MD) sind so angeordnet, dass sie die Vorgänge ausführen
, die darin bestehen, die Erzeugung von fünf aufeinanderfolgenden Stromimpulsen zu steuern und das gewählte Profil zu haben.

3. Fahrzeug nach einem der Ansprüche 1 bis 2, **dadurch gekennzeichnet, dass** der Prozessor (PR) und der Speicher (MD) für die Ausführung ausgelegt sind
Operationen , die darin bestehen, einen Zwischen-Innenwiderstand für jeden Stromimpuls zu bestimmen, dann diese Zwischen-Innenwiderstände jeweils mit ersten ausgewählten Gewichtungskoeffizienten zu multiplizieren, um gewichtete Innenwiderstände zu erhalten , und dann den tatsächlichen Innenwiderstand zu bestimmen, indem eine Summe der gewichteten Innenwiderstände dividiert wird die Summe der Gewichtungskoeffizienten.

4. Fahrzeug nach einem der Ansprüche 1 bis 3, **dadurch gekennzeichnet, dass** der Prozessor (PR) und der Speicher (MD) für die Ausführung ausgelegt sind
Operationen , die darin bestehen, die für jeden Stromimpuls gemessenen Spannungen jeweils mit ausgewählten Gewichtungskoeffizienten zu multiplizieren, um gewichtete Spannungen zu erhalten, und dann eine tatsächliche Spannung zu bestimmen, indem eine Summe der gewichteten Spannungen dividiert durch die Summe der Gewichtungskoeffizienten durchgeführt wird.

5. Fahrzeug nach einem der Ansprüche 1 bis 4, **dadurch gekennzeichnet, dass** es einen Schalter (ID) umfasst, der zwischen der Nutzbatterie (BS) und dem Bordnetz (RB) installiert ist und einen aktivierten Zustand aufweist, in dem er geöffnet oder geschlossen sein kann den Stromdurchgang zu verbieten oder zu genehmigen, und darin gesagt
Prozessor (PR) und Speicher (MD) sind so angeordnet, dass sie, wenn die Diagnose der
Versorgungsbatterie (BS) und ihrer Anschlüsse angefordert wird, die Vorgänge ausführen, die darin bestehen, zu steuern, ob der Schalter (ID) in seinen aktivierten Zustand versetzt und dann aktiviert wird Öffnen, um eine Spannungsabsenkung der Servicebatterie (BS) herbeizuführen, und im Falle der Feststellung einer Differenz zwischen den Spannungen der Servicebatterie (BS) und des Bordnetzes (RB), diese zu steuern Erzeugung aufeinanderfolgender Stromimpulse.

6. Fahrzeug nach Anspruch 5, **dadurch gekennzeichnet, dass** der Prozessor (PR) und der Speicher (MD) zur Ausführung der Operationen ausgelegt sind
bestehend aus der Steuerung des Öffnens des Schalters (ID) durch Auslösen der Zufuhr eines weiteren Stromimpulses zu diesem (ID).

7. Fahrzeug nach einem der Ansprüche 1 bis 6, **dadurch gekennzeichnet, dass** es einen Satz elektronischer Komponenten (EC) umfasst, die auf Befehl des Prozessors (PR) und des Speichers (MD) den Strom mit dem vordefinierten Profil erzeugen.

8. Diagnoseverfahren für ein Fahrzeug (V) mit einer Batterie
Energieversorger (BS), der über Verbindungen ein Bordnetz (RB) elektrisch versorgt, und einen Schritt (10-140) umfasst, in dem wir, wenn eine Diagnose der Energieversorgungsbatterie (BS) und ihrer Verbindungen angefordert wird, eine Generation von prüfen mindestens zwei aufeinanderfolgende Stromimpulse und mit einem Profil, das so gewählt ist, dass die Versorgungsbatterie (BS) einen Strom verbraucht, und während jedes Impulses mindestens eine Messung eines von der Versorgungsbatterie verbrauchten Stroms (BS) und einer Spannung an den Anschlüssen ausgelöst wird der besagten Servicebatterie (BS), dann wirermittelt aus diesen verbrauchten Strömen und gemessenen Spannungen einen tatsächlichen Innenwiderstand und löst dann die Abgabe eines ersten Alarmsignals aus, wenn der tatsächliche Innenwiderstand kleiner als ein erster ausgewählter Schwellenwert ist, **dadurch gekennzeichnet, dass** jeder Stromimpuls einen ersten umfasst
einen Teil mit einer Dauer zwischen 4 ms und 8 ms und einer Intensität zwischen 60 A und 120 A und einen zweiten Teil, der auf den ersten Teil folgt und eine Dauer zwischen 4 ms und 8 ms und eine Intensität zwischen 5 A und 15 HAS aufweist.

9. Computerprogrammprodukt mit einer Reihe von Anweisungen, die
wenn es durch Verarbeitungsmittel ausgeführt wird, ist es in der Lage,
das Diagnoseverfahren nach Anspruch 8 zu implementieren, um einen Zustand einer Versorgungsbatterie (BS) zu diagnostizieren, die über Verbindungen ein Bordnetz (RB) eines Fahrzeugs (V) elektrisch versorgt.

## Claims

1. Vehicle (V) comprising a service battery (BS) electrically supplying an on-board network (RB) via connections, and further comprising at least one processor (PR) and at least one memory (MD) arranged,
when a diagnosis of said service battery (BS) and its connections is requested, to carry out the operations consisting in controlling a generation of at least two successive current pulses and having a profile chosen so that said service battery (BS) consumes a current, and during each pulse to trigger at least one measurement of a current consumed by said service battery (BS) and a voltage at the terminals of said service battery (BS), then determining an actual internal resistance from these consumed currents and measured voltages, then triggering the delivery of a first alert signal when said actual internal resistance is lower than a first chosen threshold , **characterized in that** each pulse current comprises a first part having a duration of between 4 ms and 8 ms and an intensity of between 60 A and 120 A, and a second part following said first part and having a duration of between 4 ms and 8 ms and an intensity of between 5 A and 15 A.

2. Vehicle according to claim 1, **characterized in that** said
processor (PR) and memory (MD) are arranged to perform the operations of controlling the generation of five successive current pulses having said chosen profile.

3. Vehicle according to one of claims 1 to 2, **characterized in that** said processor (PR) and memory (MD) are arranged to carry out the
operations consisting in determining an intermediate internal resistance for each current pulse, then multiplying these intermediate internal resistances respectively by first weighting coefficients chosen in order to obtain weighted internal resistances , then determining said real internal resistance by carrying out a sum of said weighted internal resistances divided by the sum of said weighting coefficients.

4. Vehicle according to one of claims 1 to 3, **characterized in that** said processor (PR) and memory (MD) are arranged to carry out the
operations consisting in multiplying said voltages measured for each current pulse respectively by weighting coefficients chosen in order to obtain weighted voltages, then in determining a real voltage by carrying out a sum of said weighted voltages divided by the sum of said weighting coefficients.

5. Vehicle according to one of claims 1 to 4, **characterized in that** it comprises a switch (ID) installed between said service battery (BS) and said on-board network (RB) and having an activated state in which it can be opened or closed to prohibit or authorize the passage of current, and **in that** said
processor (PR) and memory (MD) are arranged, when said diagnosis of the service battery (BS) and its connections is requested, to perform the operations consisting of controlling a placement of said switch (ID) in its activated state then its opening to cause a decrease in a voltage of said service battery (BS), and, in the event of detection of a difference between the voltages of said service battery (BS) and said on-board network (RB), to control said generation of successive current pulses.

6. Vehicle according to claim 5, **characterized in that** said processor (PR) and memory (MD) are arranged to carry out the operations
consisting in controlling said opening of the switch (ID) by triggering the supply to the latter (ID) of another current pulse.

7. Vehicle according to one of claims 1 to 6, **characterized in that** it comprises a set of electronic components (EC) generating, on the orders of said processor (PR) and memory (MD), said current having the predefined profile.

8. Diagnostic method for a vehicle (V) comprising a battery of
servitude (BS) electrically supplying an on-board network (RB) via connections, and comprising a step (10-140) in which, when a diagnosis of said servitude battery (BS) and its connections is requested, a generation of at least two successive current pulses is controlled, having a profile chosen so that said servitude battery (BS) consumes a current, and during each pulse at least one measurement of a current consumed by said servitude battery (BS) and of a voltage at the terminals of said servitude battery (BS) is triggered, then
determines an actual internal resistance from these consumed currents and measured voltages, then the delivery of a first alert signal is triggered when said actual internal resistance is lower than a first chosen threshold, **characterized in that** each current pulse comprises a first
part having a duration of between 4 ms and 8 ms and an intensity of between 60 A and 120 A, and a second part following said first part and having a duration of between 4 ms and 8 ms and an intensity of between 5 A and 15 A.

9. Computer program product comprising a set of instructions which,
when executed by processing means, is capable of implementing
the diagnostic method according to claim 8 for diagnosing a state of a service battery (BS) electrically supplying an on-board network (RB) of a vehicle (V) via connections.
